# EUROPEAN PATENT APPLICATION

(11) **EP 4 202 919 A1**
(43) Date of publication of application: **28.06.2023**
(21) Application number: 22211612.1
(22) Date of filing: 06.12.2022
(51) Int. Cl.: G10K 11/24

(54) **DEFECT-BASED MEMS PHONONIC CRYSTAL SLAB WAVEGUIDE**

(30) Priority: 22.12.2021 US 202117559534
(71) Applicant: STMicroelectronics S.r.l., 20864 Agrate Brianza (MB) (IT)
(72) Inventor: ZEGA, Valentina, 63821 PORTO SANT'ELPIDIO (FM) (IT); FALORNI, Luca Giuseppe, 20812 LIMBIATE (MB) (IT); FRANGI, Attilio, 20144 MILANO (IT); GAZZOLA, Chiara, 29122 PIACENZA (IT)
(74) Representative: Studio Torta S.p.A.

(57) **Abstract**

A MEMS based device (100) includes a phononic crystal body (130) formed from unit cells (131) and having a defect line (141) extending through the phononic crystal body. Unit cells inside of the defect line (141) lack a same phononic bandgap as the unit cells outside of the defect line. An input MEMS resonator (110) is mechanically coupled to a first end of the defect line, and an output MEMS resonator (150) is mechanically coupled to a second end of the defect line. Each of the unit cells (131) outside of the defect line has an identical geometry. The input MEMS resonator (110) and output MEMS resonator (150) each have a natural frequency within the same phononic bandgap possessed by the unit cells (131) outside of the defect line. There may be more than one defect line, and in such cases, the MEMS device may include more than one input MEMS resonator and/or more than one output MEMS resonator.

## Description

### TECHNICAL FIELD

The present invention is related to the field of phononic crystals and, in particular, to the use of a phononic crystal with intentionally formed defects as a waveguide, such as may be used to connect two micro-electro mechanical systems (MEMS) resonators.

### BACKGROUND

A phonon is a collective excitation in a periodic, elastic arrangement of atoms or molecules in condensed matter, such as solids and liquids. In greater detail, a phonon is an excited state in the quantum mechanical quantization of the modes of vibrations for elastic structures of interacting particles and can be thought of as a quantized sound wave.

A phononic crystal is an artificial functional composite formed by periodic scatters embedded in a matrix, is designed to control, direct, and manipulate phonons, and is formed by periodic variation of acoustic properties of the material (e.g., elasticity, mass, etc.). A phononic crystal may have a band gap, which effectively prevents phonons of selected ranges of frequencies from being transmitted through the phononic crystal. The formation of such bandgaps is caused by the Bragg scattering phenomenon, meaning that the frequency range of the bandgap is directly proportional to the size of the unit cells of the phononic crystal.

By utilizing a phononic crystal with a band gap, a highly effective waveguide can be created. In particular, a phononic crystal with a band gap that encompasses the frequency of the phonons/waves to be transmitted through the phononic crystal is created so as to have a defect line extend therethrough. The geometric or material properties of the unit cells within the phononic crystal along the defect line are altered so that the frequency of the phonons/waves to be transmitted can in fact pass through those unit cells. Thus, a waveguide results since the phonons/waves to be transmitted propagate along the defect line but cannot propagate through other portions of the phononic crystal.

It is envisioned that the use of such phononic crystal-based waveguides can permit the creation of useful MEMS devices.

Proposed phononic crystal-based waveguides have however the problem that they have a large bulk; they cannot be easily read with current technology devices and/or they are not optimized to transmit energy.

An aim of the invention is to overcome the problems of the prior art.

### SUMMARY

According to the invention, a defect-based MEMS phononic crystal slab waveguide and a method of transmitting phonons are provided, as defined by the claims.

### BRIEF DESCRIPTION OF THE DRAWINGS

FIG. 1 is a block diagram of a MEMS device disclosed herein including a phononic crystal waveguide and two MEMS resonators coupled by the crystal waveguide.
FIG. 2 is a detailed diagram of a unit cell such as may be used to form the phononic crystal waveguide of FIG. 1.
FIG. 3 is a diagram of the irreducible Brillouin zone of the unit cell of FIG. 2.
FIG. 4 is a dispersion diagram of the unit cell of FIG. 2.
FIG. 5 is a detailed diagram of a first embodiment of the MEMS device of FIG. 1.
FIG. 5A is a greatly enlarged view of a corner of the phononic waveguide of the MEMS device of FIG. 1 illustrating a spring extending from a unit cell located at the illustrated corner of the phononic waveguide to an anchor, the spring serving to suspend the phononic waveguide over a substrate to which the anchor is affixed.
FIG. 5B is a diagrammatical perspective view of the phononic waveguide corner shown in FIG. 5A.
FIG. 5C is a diagrammatical cross sectional view of the device of FIG. 5 as a whole.
FIG. 6 is a diagram illustrating out-of-plane phonons or waves propagating through the phononic crystal waveguide of FIG. 5 and resulting energy transfer.
FIG. 7 is a diagram of the first embodiment of the MEMS device of FIG. 5 illustrating positioning of the drive and sense electrodes along the defect line and underneath the resonators.
FIG. 8 is a side view of the average line of the deformed phononic waveguide (when out-of-plane waves are propagating) and of the underlying drive and sense electrodes of FIG. 7.
FIG. 9 is a detailed diagram of a second embodiment of the MEMS device of FIG. 1.
FIG. 10 is a detailed close up diagram of the geometry of the drive electrodes of FIG. 9.
FIG. 10A is a detailed close up diagram of the geometry of the sense electrodes of FIG. 9.
FIGS 10B-10C are greatly enlarged perspective views of the unit cell and drive electrodes of FIG. 9.
FIG. 10D is a greatly enlarged side view of the unit cell and drive electrodes of FIG. 9.
FIG. 11 is a diagram illustrating in-plane phonons or waves propagating through the phononic crystal waveguide of FIG. 9 and resulting energy transfer.
FIGS. 12-13 are diagrams illustrating in-plane and out-of-plane phonons or waves both simultaneously propagating through a third embodiment of the phononic crystal waveguide and the resulting energy transfer.
FIG. 14 is a diagram of a fourth embodiment of the MEMS device of FIG. 1 illustrating unequal geometry between the input and output resonators.
FIG. 15 is a diagram illustrating the propagation of phonons or waves through the fourth embodiment of the phononic crystal waveguide of FIG. 14 and the resulting energy transfer.
FIG. 16 is a diagram of a fifth embodiment of the MEMS device of FIG. 1 illustrating multiple defect lines within the phononic crystal waveguide and the use of multiple input resonators and a single output resonator.
FIG. 17 is a diagram illustrating the propagation of phonons or waves through the fifth embodiment of the phononic crystal waveguide of FIG. 16 and the resulting energy transfer.
FIGS. 18A-18D illustrate possible designs for the unit cell such as may be used to form the phononic crystal waveguide of FIG. 1.
FIGS. 19A-19D illustrate possible designs for the resonators such as may be used to form the phononic crystal waveguide of FIG. 1.

### DESCRIPTION OF EMBODIMENTS

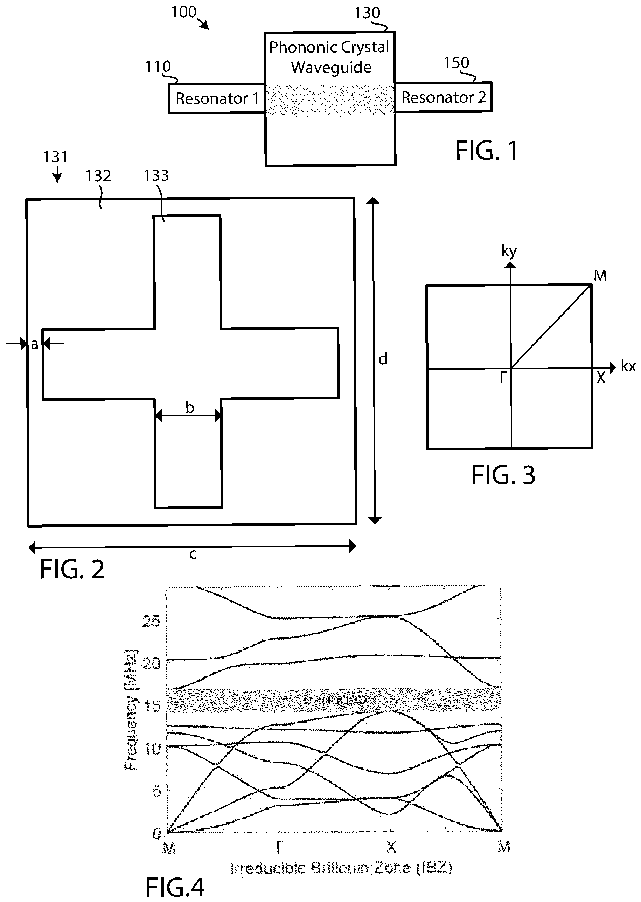

With initial reference to FIG. 1, disclosed herein is a MEMS device 100 formed by a phononic crystal waveguide 130 coupling first 110 and second 150 MEMS resonators.

The use of the phononic crystal waveguide 130, as opposed to another type of waveguide, helps to mitigate anchor losses, and provides for a highly efficient coupling between the first MEMS resonator 110 and second MEMS resonator 150.

In addition, the use of the phononic crystal waveguide 130 permits the first MEMS resonator 110 and second MEMS resonator 150 to be located at significant distance from one another (e.g., in a range of millimetres up to centimeters).

Fabrication of the phononic crystal waveguide 130 with the MEMS technology allows manufacture using standard MEMS fabrication steps at comparable low cost.

As will be described below, the input resonator 110 and output resonator 150 may have the same geometry, and may be (but may in some configurations not be) configured to exhibit a natural frequency (resonant frequency) within the bandgap of the phononic crystal waveguide 130 when activated by a same wave type (e.g., flexural wave, pressure wave, shear wave, etc.).

Construction of the phononic crystal waveguide 130 itself will first be described, and then specific embodiments and their operation will be described.

Referring now to FIG. 2, a unit cell 131 from which the phononic crystal waveguide 130 may be constructed is shown. The unit cell 131 is a crossed square, with a length and width (dimensions c and d) of 123 µm each, a depth (dimension b) of 24µm, and a distance from the edge (dimension a) of 6 µm, although it should be understood that the unit cell 131 may instead have different dimensions. The unit cell 131 is formed by a polysilicon matrix 132, with inclusions forming a cross shape 133, indicated as a hole.

The irreducible Brillouin zone for the unit cell 131 is illustrated in FIG. 3, and from this the dispersion diagram of the unit cell, as shown in FIG. 4, can be determined. Notice the wide bandgap from 14 MHz to 16.8 MHz, meaning that phonons or waves having a frequency in this range will be highly attenuated and not pass through the phononic crystal waveguide 130 formed by the periodic repetition of the unit cells 131.

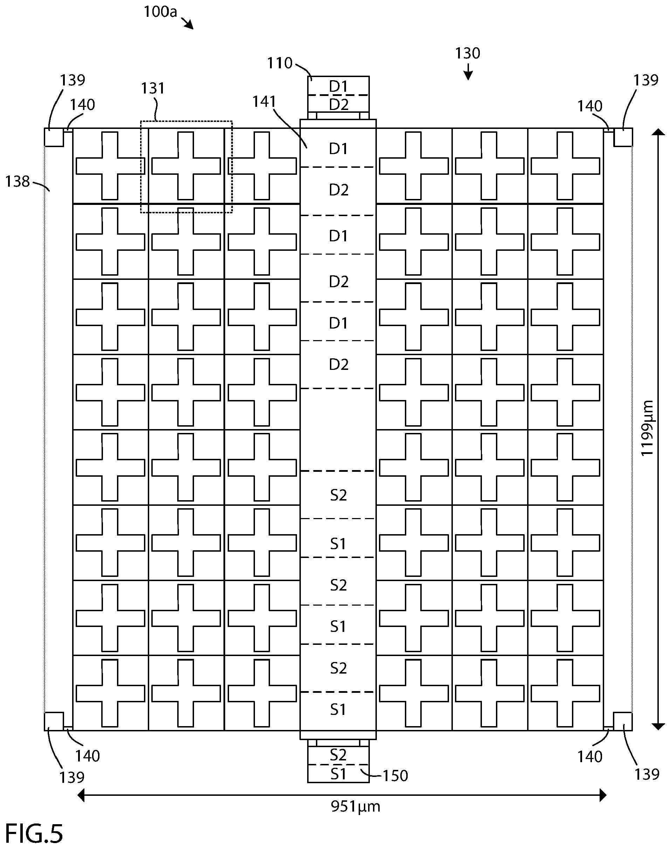

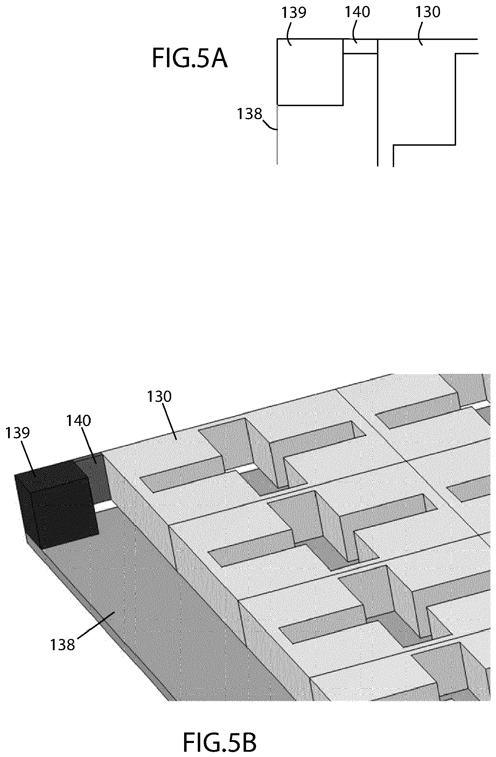

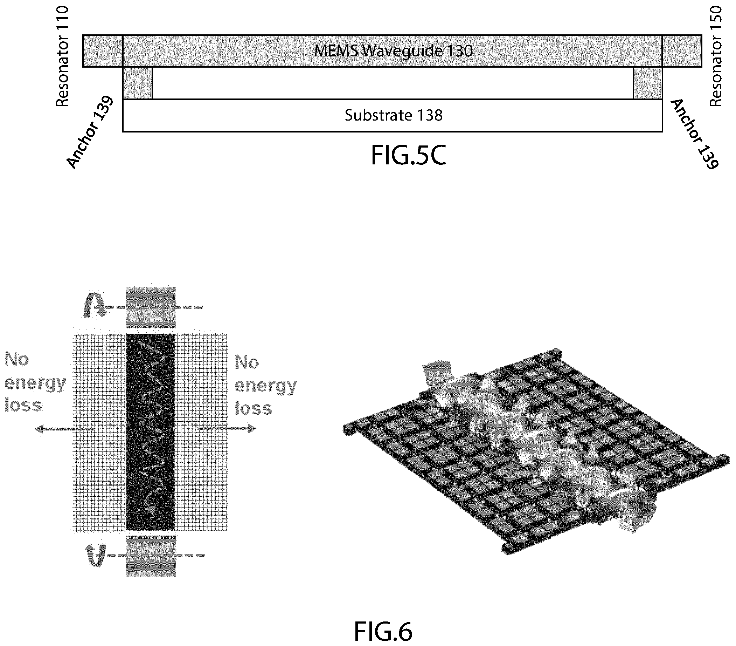

A MEMS device 100a formed using the unit cell 131 described above is now described with reference to FIG. 5. Here, the MEMS device 100a includes a phononic crystal waveguide 130 formed using a 7x8 repetition of the unit cell 131 and having a defect line 141 formed therein. The unit cells along the defect line 141 lack the cross shape 133 or any other hole, or may be constructed from different materials than the unit cells outside of the defect line.

At each corner of the phononic crystal waveguide 130 is a suspension spring 140, illustratively a straight spring, used to connect the phononic crystal waveguide 130 to an anchoring point 139, the spring suspending the phononic crystal waveguide 130 over a substrate 138. An enlarged overhead view of this arrangement may be observed in FIG. 5A, an enlarged perspective view of this arrangement may be observed in FIG. 5B, and a cross sectional view of the device as a whole may be observed in FIG. 5C. With specific reference to the perspective view in FIG. 5B, it can be noticed that the straight springs 140 are flat and extend in a plane perpendicular to the plane in which the substrate 138 extends.

Referring back to FIG. 5, the input resonator 110 is anchored to the phononic crystal waveguide 130 adjacent a first end of the defect line 141, and the output resonator 150 is anchored to the phononic crystal waveguide 130 adjacent a second end of the defect line 141. The input resonator 110 and output resonator 150 are illustratively formed as a rectangular mass anchored to the phononic crystal waveguide 130 by two straight springs, with the sizing and dimensioning of these components being such to cause the resonators, when properly excited, to exhibit the natural frequency (resonant frequency) of the out-of-plane flexural mode within the bandgap.

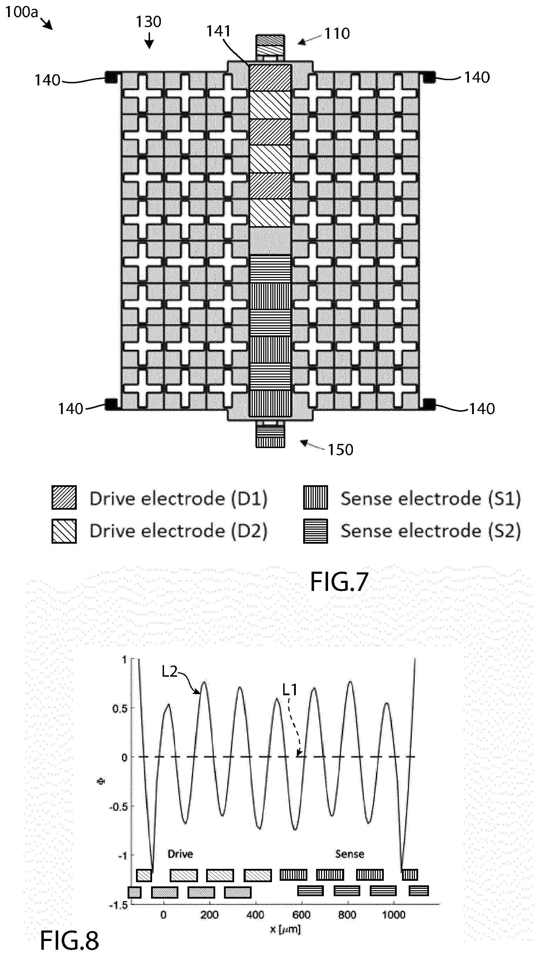

Parallel plate drive electrodes D1, D2 and sense electrodes S1, S2 are affixed to the substrate underlying the phononic crystal waveguide 130 below the defect line 141. In particular, drive electrodes D1, D2 are arranged in a geometry such that they are staggered with respect to one another (alternating drive electrodes D1, D2) in a direction along the longitudinal axis of the phononic crystal waveguide 130 extending from the input resonator 110 toward a midpoint of the phononic crystal waveguide 130, and are spaced apart from one another in a direction along the axis of thickness of the phononic crystal waveguide 130 at a properly designed gap. Sense electrodes S1, S2 are likewise arranged in a geometry such that they are staggered with respect to one another (alternating sense electrodes S1, S2) along the longitudinal axis of the phononic crystal waveguide 130 extending from the output resonator 150 toward a midpoint of the phononic crystal waveguide 130, and spaced apart from one another along the axis of thickness of the phononic crystal waveguide 130 at a properly designed gap. A diagrammatical side view of the geometry of the drive electrodes D1, D2 and sense electrodes S1, S2 may be observed at the bottom of the graph of FIG. 8.

For sake of illustration, in FIGs 7 and 8, drive electrodes D1, D2 are shown with hatchings at, respectively, +45° and -45°, and sense electrodes S1, S2 are shown with, respectively, vertical and horizontal hatchings.

This geometric arrangement of the drive electrodes D1, D2 is such that push-pull electrostatic actuation of the input resonator 110 is assisted by the drive electrodes D1, D2 when excited by a suitable drive signal during operation to cause out-of-plane flexural forces to be applied from the input resonator 110 to the phononic crystal waveguide 130. As illustrated in FIG. 6, due to the fact that the applied out-of-plane flexural forces cause the generation and propagation of phonons or waves having a frequency within the bandgap of the unit cells 131, the phonons or waves are constrained to travel through the defect line 141 from the input resonator 110 to the output resonator 150, reducing or eliminating the possibility of energy loss outside of the defect line 141. Differential readout of the sense electrodes S1, S2 is performed to detect the movement induced in the output resonator 150 by the applied out-of-plane flexural forces.

A top view of the physical arrangement of the drive electrodes D1, D2 and sense electrodes S1, S2 may also be observed in FIG. 7, with the graph of FIG. 8 illustrating the average line of the deformed waveguide during operation (line L2), to be compared with the average line of the undeformed waveguide (line L1).

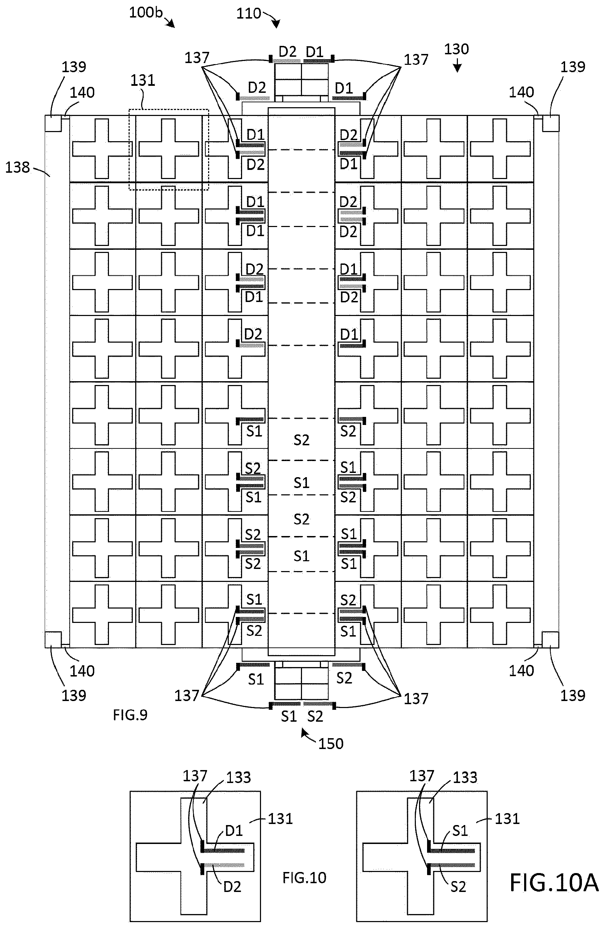

It should be appreciated that the input resonator 110 need not impart, or need not solely impart, out-of-plane flexural forces to the phononic crystal waveguide 130 to cause the generation and propagation of corresponding phonons or waves through the defect line 141. For example, in-plane flexural forces may instead be imparted, as shown in FIG. 9. Here, the input resonator 110 and output resonator 150 of the phononic crystal waveguide 130 are sized and shaped so as to exhibit the natural frequency of the in-plane flexural mode within the bandgap of the unit cells 131.

A first set of parallel plate drive electrodes D1, D2 underlies the input resonator 110 on opposite sides of the longitudinal axis of the input resonator 110, are anchored to the substrate 138 by anchors 137, and are spaced apart from the input resonator 110 by a properly designed in-plane gap. Similarly, a first set of parallel plate sense electrodes S1, S2 underlies the output resonator 150 on opposite sides of the longitudinal axis of the output resonator 150, are anchored to the substrate 138 by anchors 137, and are spaced apart from the output resonator 150 by a properly designed in-plane gap. The first set of parallel plate drive electrodes D1, D2 and the first set of parallel plate sense electrodes S1, S2 are oriented perpendicularly to the longitudinal axis of the phononic crystal waveguide 130. The thickness of the first set of parallel plate drive electrodes D1, D2 is the same as that of the input resonator 110, and the thickness of the first set of parallel plate sense electrodes S1, S2 is the same as that of the output resonator 150.

A second set of parallel plate drive electrodes D1, D2 underlies the phononic crystal waveguide 130 on opposite sides of the defect line 141 along the longitudinal axis of the phononic crystal waveguide 130, from the input resonator 110 toward the midpoint of the phononic crystal waveguide 130, with drive electrodes D1, D2 being oriented perpendicularly to the longitudinal axis of the phononic crystal waveguide 130. These drive electrodes D1, D2 are spaced apart from the phononic crystal waveguide 130 by a properly designed in-plane gap and are anchored to the substrate 138 by anchors 137. The thickness of the second set of parallel plate drive electrodes D1, D2 is the same as that of the phononic crystal waveguide 130.

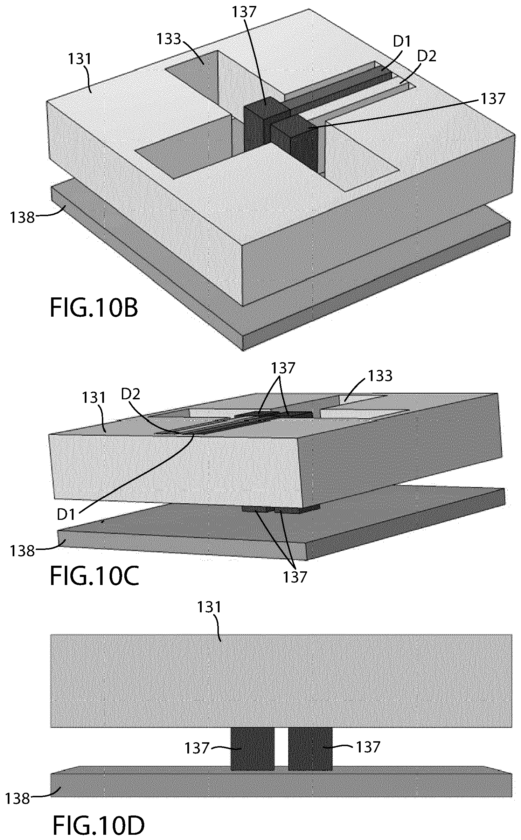

The specific geometry of the placement of these drive electrodes D1, D2 with respect to each other is shown in FIG. 9, and it can be noticed that the drive electrodes D1, D2 are located in the holes 133 of the unit cells 131. Additionally, an enlarged top view of the drive electrodes D1, D2 and the anchors 137 anchoring them to the substrate 138 may be seen in FIG. 10. The anchors 137 anchoring the drive electrodes D1, D2 to the substrate 138 may be best seen in the enlarged perspective views of FIGS. 10B and 10C, and in the enlarged side view of FIG. 10D. Note that the thickness of the drive electrodes is the same as that of the phononic crystal waveguide 130 and the resonators 110, 150, as can be best seen in the enlarged perspective view of FIG. 10B.

A second set of parallel plate sense electrodes S1, S2 underlies the phononic crystal waveguide 130 on opposite sides of the defect line 141 along the longitudinal axis of the phononic crystal waveguide 130, from the output resonator 150 toward the midpoint of the phononic crystal waveguide 130, with sense electrodes S1, S2 being oriented perpendicularly to the longitudinal axis of the phononic crystal waveguide 130. These sense electrodes S1, S2 are spaced apart from the phononic crystal waveguide 130 by a properly designed in-plane gap and are anchored to the substrate 138 by anchors 137. The thickness of the second set of parallel plate sense electrodes S1, S2 is the same as that of the phononic crystal waveguide 130.

The specific geometry of the placement of these sense electrodes S1, S2 with respect to each other is shown in FIG. 9, and it can be noticed that the sense electrodes S1, S2 are located in the holes 133 of the unit cells 131. Additionally, an enlarged top view of the sense electrodes S1, S2 and the anchors 137 anchoring them to the substrate 138 may be seen in FIG. 10A. Note that the thickness of the sense electrodes is the same as that of the phononic crystal waveguide 130 and the resonators 110, 150.

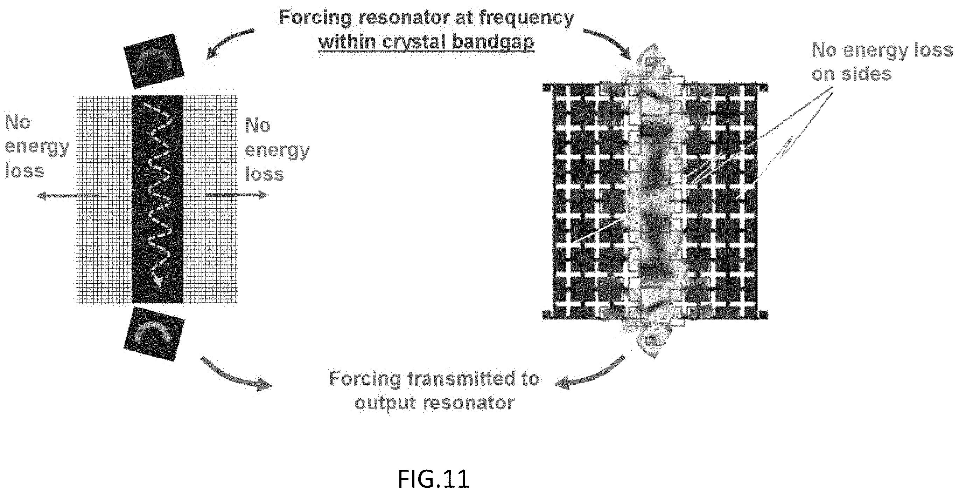

This geometric arrangement of the drive electrodes D1, D2 is such that push-pull electrostatic actuation of the input resonator 110 is assisted by the drive electrodes D1, D2 when excited by a suitable drive signal during operation to cause in-plane flexural forces to be applied from the input resonator 110 to the phononic crystal waveguide 130. As illustrated in FIG. 11, due to the fact that the applied in-plane forces activate in-plane flexural deformations of the input resonator 110 to thereby cause the generation and propagation of phonons or waves having a frequency within the bandgap of the unit cells 131, the phonons or waves are constrained to travel through the defect line 141 from the input resonator 110 to the output resonator 150, reducing or eliminating the possibility of energy loss outside of the defect line 141. Differential readout of the sense electrodes S1, S2 is performed to detect the movement induced in the output resonator 150 by the applied in-plane forces.

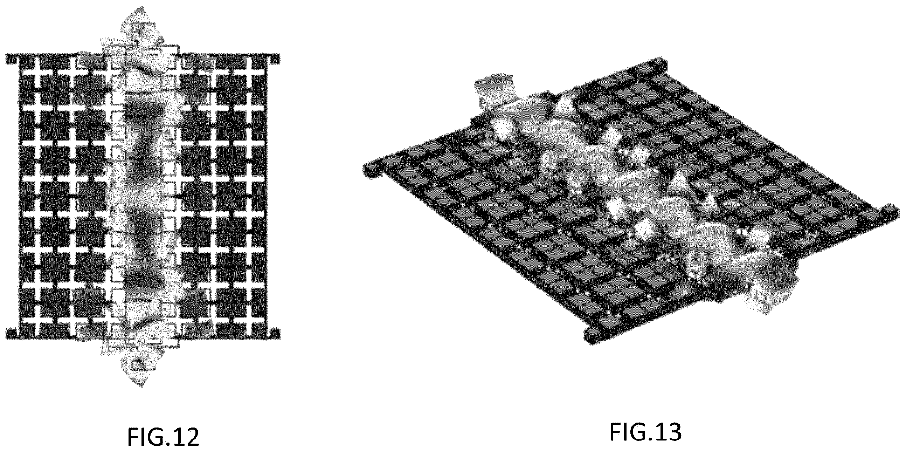

As can be appreciated, the above embodiments may be combined, and the input resonator and output resonator may be sized and shaped so as to impart both in-plane and out-of-plane flexural forces to the phononic crystal waveguide 130, as shown in FIG. 12. Accordingly, the drive electrodes D1, D2 may be positioned so as to assist imparting in-plane and out-of-plane flexural forces to the phononic crystal waveguide 130, and the sense electrodes S1, S2 may be positioned so as to permit differential sensing to detect the propagated phonons or waves. The propagated in-plane phonons or waves may be seen in FIG. 12, with the propagated out-of-plane phonons or waves may be seen in FIG. 13.

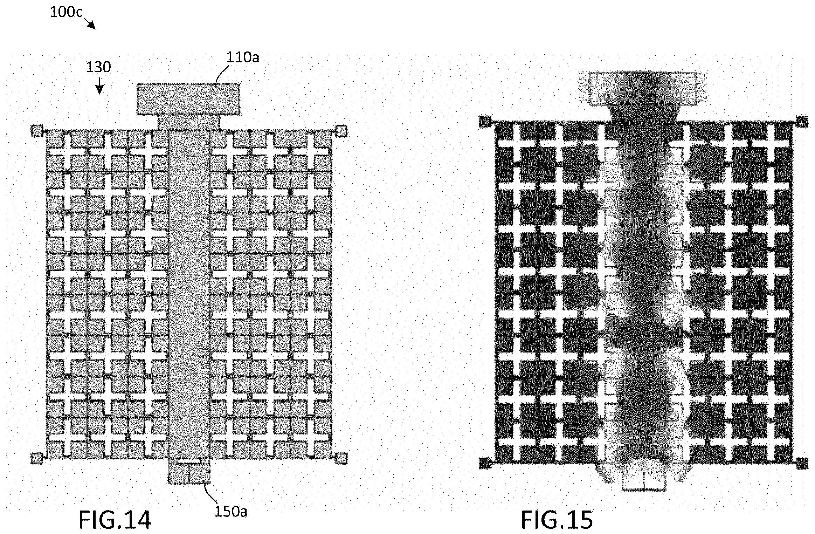

In the instances shown above, the input resonator 110 and output resonator 150 have the same shape, but that need not be so. For example, as shown in FIG. 14, the input resonator 110a may have a different geometry than the output resonator 150a, and may have a natural frequency that is not within the bandgap of the unit cell 131 while the output resonator 150a may have a smaller rigidity (stiffness) and a natural frequency within the bandgap of the unit cells 131. The result from this is enhanced transmission, for example with the output being amplified with respect to the input, as may be observed in FIG. 15.

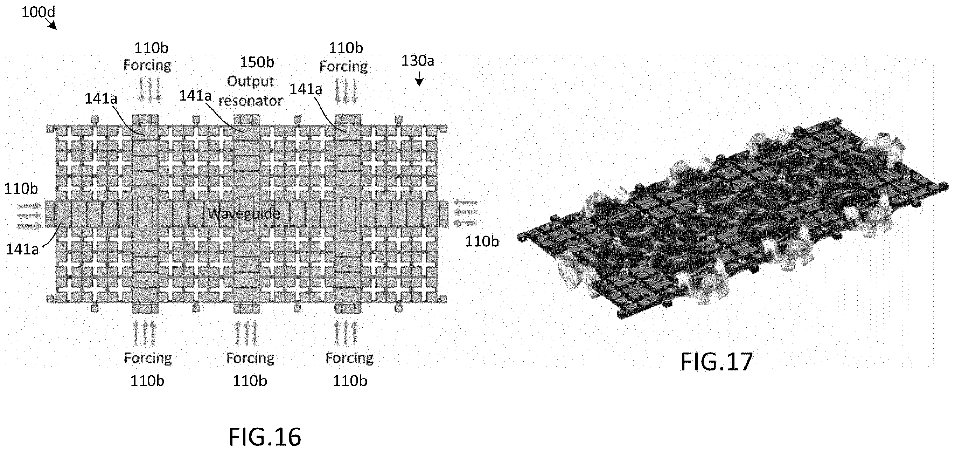

In the instances shown above, the phononic crystal waveguide 130 has a single defect line 141 defined therein, but instead, as shown in FIG. 16, multiple defect lines 141a (formed of unit cells lacking holes) may be defined in the phononic crystal waveguide 130a.

In such an instance, there may be multiple input resonators 110b and a single output resonator 150b, with the single output resonator 150b being at one end of one defect line 141a, an input resonator 110b being at the other end of that defect line 141a, and additional input resonators 110b being at both ends of the other defect lines 141a.

In the instance of FIG. 16, the input resonators 110b and the output resonator 150b each have identical geometries, are each out-of-plane resonators, and each have a natural frequency within the bandgap of the unit cells 131. Operation can be observed in FIG. 17, where the applied out-of-plane flexural forces cause the generation and propagation of phonons or waves from the input resonators 110b to the output resonator 150b.

The above described embodiments utilize drive and sense electrodes to contribute to the generation of phonons or waves to be transmitted through the waveguide and to the sensing of those transmitted phonons or waves at the output of the waveguide. However, drive and sense electrodes are not necessary along the phononic crystal waveguide, and all of the above embodiments are functional and commercially useful without the use of drive and sense electrodes in those specific positions, or without the use of drive electrodes in those specific positions but with the use of sense electrodes, or with the use of drive electrodes but without the use of sense electrodes in those specific positions. Sense and drive electrodes placed under and/or about the resonators are sufficient to start the propagation of waves or phonons through the phononic crystal waveguide. It should be appreciated that the imparting of movement to the input resonator may be effectuated other than electrostatically, and that all ways of imparting such movement are within the scope of this disclosure.

Finally, it is clear that modifications and variations may be made to what has been described and illustrated herein, without thereby departing from the scope of this disclosure, as defined in the annexed claims.

For example, while the previously described unit cell 131 used to form the phononic waveguides 130 has been described as having specific dimensions and a specific shaped hole 133, other shapes may be used.

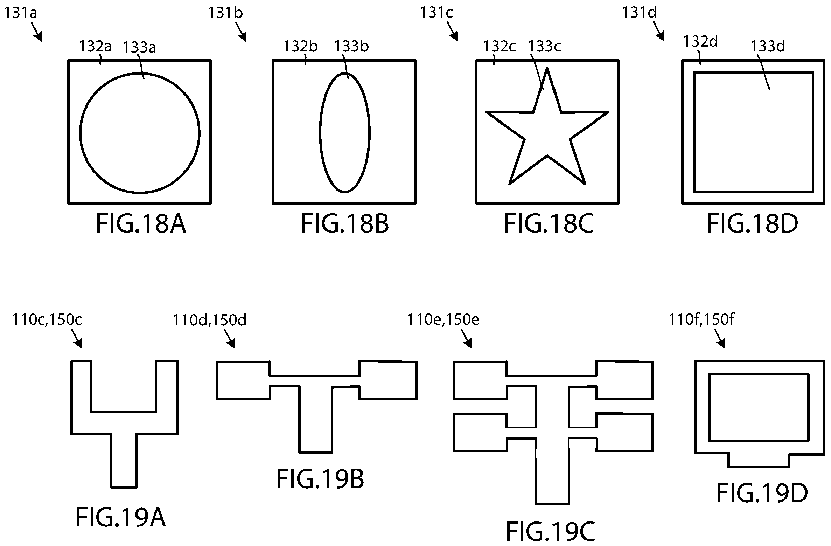

For example, as shown in FIG. 18A, the unit cell 131a may instead have a circular hole 133a defined therein; as shown in FIG. 18B, the unit cell 131b may instead have an oval shaped hole 133b defined therein; as shown in FIG. 18C, the unit cell 131c may instead have a five-pointed star shaped hole 133c defined therein; and, as shown in FIG. 18D, the unit cell 131d may instead have a rectangularly shaped hole 133d defined therein.

Also, the previously described input resonator 110 and output resonator 150 may have a variety of different geometries. For example, as shown in FIG. 19A, the input resonator 110c and output resonator 150c may be tuning-fork shaped; as shown in FIG. 19B, the input resonator 110d and output resonator 150d may be T-shaped with enlarged ends; as shown in FIG. 19C, the input resonator 110e and output resonator 150e may be shaped as two superimposed Ts with enlarged ends; and, as shown in FIG. 19D, the input resonator 110f and output resonator 150f may be loop shaped with one side thereof having an enlarged portion. Also, the input resonator 110 may impart any sort of useful forces to the phononic crystal waveguide 130 to cause the generation and propagation of corresponding phonons through the defect line 141.

Example embodiments of the present invention are summarized here.
Example 1. A micro-electro mechanical systems (MEMS) device, comprising
   a phononic crystal body formed from unit cells and having at least one defect line extending through the phononic crystal body, wherein unit cells inside of the at least one defect line lack a same phononic bandgap as unit cells outside of the at least one defect line;
   an input MEMS resonator mechanically coupled to the at least one defect line; and an output MEMS resonator mechanically coupled to the at least one defect line.
Example 2. The MEMS device of Example 1, wherein each of the unit cells outside of the at least one defect line has an identical geometry.
Example 3. The MEMS device of Example 1, wherein the input MEMS resonator and the output MEMS resonator have an identical geometry.
Example 4. The MEMS device of Example 1, wherein the input MEMS resonator has a natural frequency within the same phononic bandgap possessed by the unit cells outside of the at least one defect line.
Example 5. The MEMS device of Example 1, wherein the input MEMS resonator and the output MEMS resonator may have different geometries.
Example 6. The MEMS device of Example 1, wherein the output MEMS resonator has a natural frequency within the same phononic bandgap possessed by the unit cells outside of the at least one defect line.
Sub-example 1. The MEMS device of Example 1, wherein the output MEMS resonator has a natural frequency within the same phononic bandgap possessed by the unit cells outside of the at least one defect line while the input MEMS resonator has a natural frequency outside of the same phononic bandgap possessed by the unit cells outside of the at least one defect line.
Example 7. The MEMS device of Example 1, wherein the input MEMS resonator and the output MEMS resonator have different stiffnesses.
Example 8. The MEMS device of Example 1, further comprising at least one pair of drive electrodes configured to cooperate with the input MEMS resonator to induce a desired mode of vibration in the phononic crystal body to thereby transmit phonons having a frequency within phononic bandgap possessed by the unit cells outside of the at least one defect line through the at least one defect line to the output MEMS resonator.
Example 9. The MEMS device of Example 1, further comprising at least one pair of sense electrodes configured to cooperate with the output MEMS resonator to thereby permit differential sensing of transmitted phonons.
Example 10. The MEMS device of Example 1, wherein the phononic crystal body has a plurality of intersecting defect lines extending therethrough; and further comprising a plurality of additional input MEMS resonators mechanically coupled to the plurality of intersecting defect lines.
Example 11. The MEMS device of Example 1, wherein the phononic crystal body has a plurality of intersecting defect lines extending therethrough; and further comprising at least one additional output MEMS resonator mechanically coupled to at least one of the plurality of intersecting defect lines.
Sub-example 2. At least one pair of drive electrodes may be configured to cooperate with the input MEMS resonator to induce a desired mode of vibration in the phononic crystal body to thereby transmit phonons having a frequency within phononic bandgap possessed by the unit cells outside of the at least one defect line through the at least one defect line to the output MEMS resonator.
Sub-example 3. The desired mode of vibration may be an out-of-plane flexural mode, or may be an in-plane flexural mode.
Sub-example 4. At least one pair of sense electrodes may be configured to cooperate with the output MEMS resonator to thereby permit differential sensing of transmitted phonons.
Sub-example 5. The phononic crystal body may have a plurality of intersecting defect lines extending therethrough, and a plurality of additional input MEMS resonators may be mechanically coupled to the plurality of intersecting defect lines.
Sub-example 6. At least one additional output MEMS resonator may be mechanically coupled to at least one of the plurality of intersecting defect lines.
Sub-example 7. The input MEMS resonator may be mechanically coupled to a first end of the at least one defect line and the output MEMS resonator may be mechanically coupled to a second end of the at least one defect line.
Example 12. A micro-electro mechanical systems (MEMS) device, comprising:
   a substrate;
   a phononic crystal body suspended over the substrate by suspension springs, the suspension springs being anchored to the substrate by an anchor;
   wherein the phononic crystal body is formed from unit cells and has a plurality of defect lines extending through the phononic crystal body, wherein unit cells inside of the plurality of defect lines lack a same phononic bandgap as unit cells outside of the plurality of defect lines;
   an input MEMS resonator mechanically coupled to at least one of the plurality of defect lines; and
   an output MEMS resonator mechanically coupled to at least one of the plurality of defect lines.
Example 13. The MEMS device of Example 12, wherein each of the unit cells outside of the plurality of defect lines have an identical geometry.
Example 14. The MEMS device of Example 12, wherein the input MEMS resonator and the output MEMS resonator have an identical geometry.
Example 15. The MEMS device of Example 12, wherein the output MEMS resonator has a natural frequency within the same phononic bandgap possessed by the unit cells outside of the plurality of defect lines while the input MEMS resonator has a natural frequency outside of the same phononic bandgap possessed by the unit cells outside of the plurality of defect lines.
Example 16. The MEMS device of Example 12, wherein the input MEMS resonator and the output MEMS resonator have different stiffnesses.
Example 17. A method of transmitting phonons, comprising:
   actuating at least one pair of drive electrodes associated with an input micro-electro mechanical systems (MEMS) resonator that is mechanically coupled to a phononic crystal body to thereby induce a desired mode of vibration in the input MEMS resonator, resulting in generation of phonons having a frequency within a phononic bandgap possessed by unit cells of the phononic crystal body outside of a defect line formed therein;
   passing the phonons through the defect line; and
   detecting the passed phonons at an output MEMS resonator by detecting vibrations induced in the output MEMS resonator by the passed phonons.
Example 18. The method of Example 17, wherein the desired mode of vibration comprises an out-of-plane flexural mode or an in-plane flexural mode.
Example 19. The method of Example 17, wherein the input MEMS resonator and the output MEMS resonator each exhibit a same natural frequency within the phononic bandgap possessed by the unit cells outside of the defect line when actuated by a same wave type.
Example 20. The method of Example 19, wherein the wave type comprises at least one of a flexural wave, a pressure wave, and a shear wave.

## Claims

1. A waveguide micro-electro mechanical systems MEMS device, comprising:
a phononic crystal body (130) forming a waveguide, formed from unit cells (131) and having at least one defect line (141) extending through the phononic crystal body (130), wherein unit cells inside of the at least one defect line (141) lack a same phononic bandgap as unit cells (131) outside of the at least one defect line;
an input MEMS resonator (110) mechanically coupled to the at least one defect line; and
an output MEMS resonator(150) mechanically coupled to the at least one defect line.

2. The MEMS device of claim 1, wherein each of the unit cells (131) outside of the at least one defect line (141) has an identical geometry.

3. The MEMS device of claim 1 or 2, wherein the input MEMS resonator (110) and the output MEMS resonator (150) have an identical geometry.

4. The MEMS device of any of claims 1-3, wherein the input MEMS resonator (110) has a natural frequency within the same phononic bandgap possessed by the unit cells (131) outside of the at least one defect line.

5. The MEMS device of any of the preceding claims, wherein the output MEMS resonator has a natural frequency within the same phononic bandgap possessed by the unit cells outside of the at least one defect line.

6. The MEMS device of any of claims 1-4, wherein the output MEMS resonator has a natural frequency within the same phononic bandgap possessed by the unit cells outside of the at least one defect line while the input MEMS resonator has a natural frequency outside of the same phononic bandgap possessed by the unit cells outside of the at least one defect line.

7. The MEMS device of any of the preceding claims, wherein the input MEMS resonator (110) and the output MEMS resonator (150) have different stiffnesses.

8. The MEMS device of any of the preceding claims, further comprising at least one pair of drive electrodes (D1, D2) configured to cooperate with the input MEMS resonator (110) to induce a desired mode of vibration in the phononic crystal body to thereby transmit phonons having a frequency within phononic bandgap possessed by the unit cells (131) outside of the at least one defect line (141) through the at least one defect line to the output MEMS resonator.

9. The MEMS device of claim 1, further comprising at least one pair of sense electrodes configured to cooperate with the output MEMS resonator (150) to thereby permit differential sensing of transmitted phonons.

10. The MEMS device of claim 1, wherein the phononic crystal body has a plurality of intersecting defect lines (141a) extending therethrough; and further comprising a plurality of additional input MEMS resonators (110b) mechanically coupled to the plurality of intersecting defect lines.

11. The MEMS device of any of the preceding claims, wherein the phononic crystal body has a plurality of intersecting defect lines extending therethrough; and further comprising at least one additional output MEMS resonator mechanically coupled to at least one of the plurality of intersecting defect lines.

12. The MEMS device of any of the preceding claims, further comprising a substrate (138), wherein the phononic crystal body (130) is suspended over the substrate by suspension springs (140), the suspension springs being anchored to the substrate by an anchor (139).

13. A method of transmitting phonons through a micro-electro-mechanical systems MEMS device having a phononic crystal body formed from unit cells (131) and having at least one defect line (141) extending through the phononic crystal body (130), wherein unit cells inside of the at least one defect line (141) lack a same phononic bandgap as unit cells (131) outside of the at least one defect line, the method comprising:
actuating at least one pair of drive electrodes associated with an MEMS resonator that is mechanically coupled to the phononic crystal body to thereby induce a desired mode of vibration in the input MEMS resonator, resulting in generation of phonons having a frequency within a phononic bandgap possessed by the unit cells outside of a defect line formed therein;
passing the phonons through the defect line; and
detecting the passed phonons at an output MEMS resonator by detecting vibrations induced in the output MEMS resonator by the passed phonons.

14. The method of the preceding claim, wherein the desired mode of vibration comprises an out-of-plane flexural mode or an in-plane flexural mode.

15. The method of claim 13 or 14, wherein the input MEMS resonator and the output MEMS resonator each exhibit a same natural frequency within the phononic bandgap possessed by the unit cells outside of the defect line when actuated by a same wave type, the wave type comprising at least one of a flexural wave, a pressure wave, and a shear wave.
